# DEMANDE DE BREVET EUROPEEN

(11) **EP 4 683 220 A1**
(43) Date de publication de la demande: **21.01.2026**
(21) Numéro de dépôt: 25188173.6
(22) Date de dépôt: 08.07.2025
(51) Int. Cl.: H03H 3/02, H03H 9/02, H03H 9/17, H03H 9/205, H03H 9/56, H03H 9/58, H03H 9/60, H03H 3/04

(54) **FILTRE A ONDES ACOUSTIQUES DE VOLUME**

(30) Priorité: 17.07.2024 FR 2407822
(71) Demandeur: STMicroelectronics International N.V., 1228 Plan-les-Ouates, Geneva (CH)
(72) Inventeur: BOUFNICHEL, Mohamed, 37380 Monnaie (FR)
(74) Mandataire: Cabinet Beaumont

(57) **Abrégé**

La présente description concerne un filtre (200) à ondes acoustiques de volume formé dans et sur un substrat semiconducteur (101), le filtre (200) comprenant :
- une cavité d'air (201) enterrée dans le substrat semiconducteur (101) ; et
- au moins un résonateur (121) formé à l'aplomb de la cavité d'air (201), le résonateur (121) comprenant une couche active (109) interposée entre des électrodes inférieure (107) et supérieure (111).

## Description

### Domaine technique

La présente description concerne de façon générale les dispositifs électroniques, plus particulièrement les filtres à ondes acoustiques de volume (« Bulk Acoustic Wave » - BAW, en anglais).

### Technique antérieure

De nombreux dispositifs électroniques comprennent au moins un filtre à ondes acoustiques de volume. De tels filtres sont par exemple intégrés dans des téléphones mobiles, ou smartphones, pour éviter que le fonctionnement d'un canal de réception de communications radiofréquence du téléphone ne soit perturbé par des interférences causées par des signaux radiofréquence émis par d'autres dispositifs électroniques, ou par du bruit provenant de sources radiofréquence externes.

Deux types de filtres à ondes acoustiques de volume ont déjà été proposés : les filtres dits « SMR » (de l'anglais « Solidly Mounted Resonator » - résonateur monté rigidement), d'une part, et les filtres dits « FBAR » (de l'anglais « thin-Film Bulk Acoustic Resonator » - résonateur acoustique en volume à film mince), également appelés filtres à ondes acoustiques de volume « à membrane », d'autre part. Un filtre SMR comprend typiquement une membrane en un matériau isolant située sur et en contact avec un miroir de Bragg et une couche piézoélectrique située sur la membrane et interposée entre des électrodes inférieure et supérieure. Un filtre FBAR diffère du filtre SMR principalement en ce que, dans le cas du filtre FBAR, le miroir de Bragg est substitué par une cavité d'air au-dessus de laquelle est suspendue la membrane. La présence de la cavité d'air confère au filtre FBAR une meilleure efficacité que celle du filtre SMR. La cavité d'air procure en effet une isolation acoustique supérieure à celle obtenue au moyen d'un miroir de Bragg présentant plusieurs bicouches (environ une quinzaine de bicouches permettraient d'obtenir une isolation équivalente à celle d'une cavité d'air, ce qui serait très difficile à réaliser en pratique), d'où il résulte des pertes énergétiques réduites.

Toutefois, les filtres à ondes acoustiques existants, notamment les filtres FBAR existants, souffrent de divers inconvénients. Les filtres FBAR sont en particulier complexes et coûteux à réaliser, car les procédés de fabrication actuels de tels filtres requièrent un contrôle précis de la planéité de la structure et mettent en œuvre une étape délicate de formation de la cavité d'air par retrait d'une couche sacrificielle. Par ailleurs, les filtres FBAR sont affectées par des problèmes d'échauffement et de robustesse mécanique. De ce fait, il s'avère difficile de miniaturiser les filtres FBAR existants.

### Résumé de l'invention

Il existe un besoin de pallier tout ou partie des inconvénients des filtres à ondes acoustiques de volume, en particulier des filtres FBAR, existants et de leurs procédés de fabrication. Il serait notamment souhaitable de simplifier les procédés de fabrication de tels filtres et de pouvoir réaliser des filtres FBAR présentant une résistance mécanique et des performances thermiques supérieures à celles des filtres FBAR existants. Cela permettrait de miniaturiser plus aisément les filtres FBAR.

Pour cela, un mode de réalisation prévoit un filtre à ondes acoustiques de volume formé dans et sur un substrat semiconducteur, le filtre comprenant :
- une cavité d'air enterrée dans le substrat semiconducteur ; et
- au moins un résonateur formé à l'aplomb de la cavité d'air, chaque résonateur comprenant une couche active interposée entre des électrodes inférieure et supérieure.

Selon un mode de réalisation, le filtre comprend un unique résonateur formé à l'aplomb de la cavité d'air.

Selon un mode de réalisation, le filtre comprend exactement des premier et deuxième résonateurs formés à l'aplomb de la cavité d'air.

Selon un mode de réalisation, les électrodes supérieures des premier et deuxième résonateurs présentent des épaisseurs différentes.

Selon un mode de réalisation, les électrodes inférieures des premier et deuxième résonateurs forment une électrode commune.

Selon un mode de réalisation, chaque électrode supérieure présente, en vue de dessus, une forme asymétrique.

Selon un mode de réalisation, le substrat semiconducteur est en silicium.

Selon un mode de réalisation, chaque résonateur est séparé de la cavité d'air par une partie du substrat semiconducteur présentant une épaisseur comprise entre 300 nm et 1,5 µm.

Un mode de réalisation prévoit un dispositif électronique, de préférence téléphone mobile ou smartphone, comprenant un circuit intégré radiofréquence comportant au moins un filtre tel que décrit.

Un mode de réalisation prévoit un procédé de fabrication d'un filtre à ondes acoustiques de volume, le procédé comprenant les étapes successives suivantes :
a) prévoir un substrat semiconducteur ;
b) former une cavité d'air enterrée dans le substrat semiconducteur ; et
c) former au moins un résonateur à l'aplomb de la cavité d'air, chaque résonateur comprenant une couche active interposée entre des électrodes inférieure et supérieure.

Selon un mode de réalisation, le procédé comprend en outre, entre les étapes a) et b), une étape de formation d'une pluralité de vias creux dans le substrat semiconducteur.

Selon un mode de réalisation, à l'étape b), la cavité d'air est formée, à partir de la pluralité de vias creux, par recuit du substrat semiconducteur sous atmosphère d'hydrogène.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de côté et en coupe, schématique et partielle, d'un exemple de filtre à ondes acoustiques de volume ;
la figure 2 est une vue de côté et en coupe, schématique et partielle, d'un exemple de filtre à ondes acoustiques de volume selon un mode de réalisation ;
la figure 3A, la figure 3B, la figure 3C, la figure 3D et la figure 3E illustrent, par des vues de côté et en coupe, schématiques et partielles, des structures obtenues à l'issue d'étapes successives d'un procédé de fabrication du filtre à ondes acoustiques de volume de la figure 2 selon un mode de réalisation ;
la figure 4 est une vue de côté et en coupe, schématique et partielle, d'un exemple de filtre à ondes acoustiques de volume selon un mode de réalisation ; et
la figure 5 est une vue de dessus, schématique et partielle, d'un exemple d'un dispositif intégrant un filtre à ondes acoustiques de volume.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, l'intégration des filtres à ondes acoustiques de volume dans les différents dispositifs électroniques susceptibles de mettre en œuvre de tels filtres n'a pas été détaillée, les modes de réalisation décrits étant compatibles avec tous ou la plupart des dispositifs électroniques intégrant au moins un filtre, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Dans la description qui suit, les qualificatifs « isolant » et « conducteur » signifient respectivement, sauf précision contraire, électriquement isolant et électriquement conducteur.

Sauf précision contraire, l'expression « en contact avec » signifie « en contact mécanique avec ».

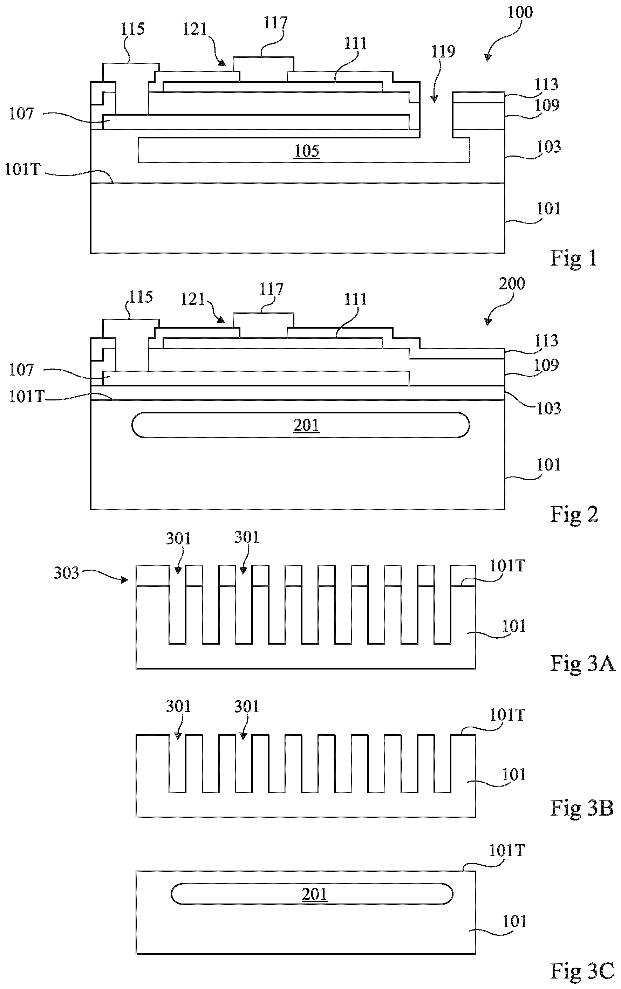

La figure 1 est une vue de côté et en coupe, schématique et partielle, d'un exemple de filtre 100 à ondes acoustiques de volume. Le filtre 100 est par exemple plus précisément de type « FBAR » (de l'anglais « thin-Film Bulk Acoustic Resonator » - résonateur acoustique en volume à film mince), ou filtre à ondes acoustiques de volume « à membrane ».

Dans l'exemple représenté, le filtre 100 comprend un substrat semiconducteur 101, par exemple une plaquette ou un morceau de plaquette en un matériau semiconducteur. À titre d'exemple, le substrat semiconducteur 101 est en silicium.

Dans l'exemple représenté, le filtre 100 comprend en outre une couche isolante 103 revêtant une face supérieure 101T du substrat semiconducteur 101. Dans l'exemple illustré, la couche isolante 103 est située sur et en contact avec toute la face supérieure 101T du substrat semiconducteur 101. La couche isolante 103 présente par exemple une épaisseur comprise entre 1,3 et 4 µm. À titre d'exemple, la couche isolante 103 est en un oxyde, par exemple l'oxyde de silicium. La couche isolante 103 fait par exemple office de couche de passivation de la face supérieure 101T du substrat semiconducteur 101.

Dans l'exemple illustré, le filtre 100 comprend en outre une cavité 105 formée dans la couche isolante 103. La cavité 105 présente par exemple une hauteur strictement inférieure à l'épaisseur de la couche isolante 103 et des dimensions latérales strictement inférieures à celles de la couche isolante 103. Dans cet exemple, les parois de la cavité 105 sont formées par le matériau de la couche isolante 103. La cavité 105 présente par exemple une hauteur comprise entre 0,3 et 2 µm. À titre d'exemple, la cavité 105 est remplie d'air. Dans l'exemple représenté, la cavité 105 présente des parois latérales sensiblement rectilignes et sensiblement verticales. Dans cet exemple, la cavité 105 présente, en vue en coupe, une forme sensiblement rectangulaire.

Dans l'exemple représenté, le filtre 100 comprend en outre une électrode 107 revêtant une partie de la face supérieure de la couche isolante 103. Dans l'exemple illustré, l'électrode 107 est située sur et en contact avec une partie de la face supérieure de la couche isolante 103. L'électrode 107 est au moins partiellement située à l'aplomb de la cavité 105. Comme dans l'exemple illustré en figure 1, l'électrode 107 est par exemple majoritairement située à l'aplomb de la cavité 105. Dans cet exemple, l'électrode 107 comprend en outre une partie minoritaire s'étendant latéralement hors de l'aplomb de la cavité 105. À titre d'exemple, l'électrode 107 est en un matériau conducteur, par exemple un métal tel que l'aluminium ou un alliage métallique.

Dans l'exemple illustré, le filtre 100 comprend en outre une autre couche isolante 109 revêtant les faces latérales et la face supérieure de l'électrode 107. Dans cet exemple, la couche isolante 109 revêt en outre des parties de la face supérieure de la couche isolante 103 non revêtues de l'électrode 107. Dit autrement, la couche isolante 109 s'étend latéralement hors de l'aplomb de l'électrode 107. La couche isolante 109 est par exemple plus précisément située sur et en contact avec les faces latérales et supérieure de l'électrode 107 et avec les parties de la face supérieure de la couche isolante 103 non revêtues de l'électrode 107. À titre d'exemple, la couche isolante 109 est une couche piézoélectrique, c'est-à-dire une couche en un matériau piézoélectrique, par exemple le niobate de lithium (« Lithium Niobate Oxide » - LNO, en anglais), le nitrure d'aluminium, etc.

Dans l'exemple représenté, le filtre 100 comprend en outre une autre électrode 111 revêtant une partie de la face supérieure de la couche isolante 109. Dans l'exemple illustré, l'électrode 111 est située sur et en contact avec une partie de la face supérieure de la couche isolante 109. L'électrode 111 est par exemple au moins partiellement située à l'aplomb de la cavité 105. Comme dans l'exemple illustré en figure 1, l'électrode 111 est par exemple totalement située à l'aplomb de la cavité 105. Dans cet exemple, l'électrode 111 présente des dimensions latérales strictement inférieures à celles de l'électrode 107. Les électrodes 111 et 107 sont par exemple respectivement des électrodes supérieure et inférieure du filtre 100. À titre d'exemple, l'électrode 111 est en un matériau conducteur, par exemple un métal tel que l'aluminium ou un alliage métallique. L'électrode 111 est par exemple en le même matériau que l'électrode 107.

L'électrode 111 présente par exemple, en vue de dessus, une forme asymétrique.

Dans l'exemple illustré, le filtre 100 comprend en outre encore une autre couche isolante 113 revêtant les faces latérales et la face supérieure de l'électrode 111. Dans cet exemple, la couche isolante 113 revêt en outre des parties de la face supérieure de la couche isolante 109 non revêtues de l'électrode 111. La couche isolante 113 est par exemple plus précisément située sur et en contact avec les faces latérales et supérieure de l'électrode 111 et avec les parties de la face supérieure de la couche isolante 109 non revêtues de l'électrode 111. À titre d'exemple, la couche isolante 113 est en un oxyde, par exemple l'oxyde de silicium. La couche isolante 113 est par exemple en le même matériau que la couche isolante 103. La couche isolante 113 fait par exemple office de couche de passivation de la face supérieure de la structure, notamment de l'électrode 111.

Dans l'exemple représenté, le filtre 100 comprend en outre des éléments de reprise de contact 115 et 117 des électrodes 107 et 111, respectivement. Dans l'exemple illustré en figure 1, l'élément de reprise de contact 115 est situé sur et en contact avec une partie de la face supérieure de l'électrode 107 située hors de l'aplomb de la cavité 105. L'élément de reprise de contact 115 présente par exemple, en vue en coupe, une forme de T comprenant une partie verticale s'étendant, depuis la face supérieure de la couche isolante 113, à travers les couches isolantes 113 et 109 jusqu'à la face supérieure de l'électrode 107 et une partie horizontale s'étendant latéralement sur et en contact avec la face supérieure de la couche isolante 113 au voisinage de la partie verticale de l'élément de reprise de contact 115.

Par ailleurs, dans cet exemple, l'élément de reprise de contact 117 est situé sur et en contact avec une partie de la face supérieure de l'électrode 111 située à l'aplomb de la cavité 105. L'élément de reprise de contact 117 présente par exemple, en vue en coupe, une forme de T comprenant une partie verticale s'étendant, depuis la face supérieure de la couche isolante 113, à travers la couche isolante 113 jusqu'à la face supérieure de l'électrode 111 et une partie horizontale s'étendant latéralement sur et en contact avec la face supérieure de la couche isolante 113 au voisinage de la partie verticale de l'élément de reprise de contact 117. Chaque élément de reprise de contact 115, 117 est en un matériau conducteur, par exemple un métal ou un alliage métallique. À titre d'exemple, les éléments de reprise de contact 115 et 117 sont en le même matériau.

Bien que cela n'ait pas été illustré en figure 1 afin de ne pas surcharger le dessin, les éléments de reprise de contact 115 et 117 sont par exemple destinés à être reliés ou connectés à un ou plusieurs composants ou circuits extérieurs au filtre 100. À titre d'exemple, les éléments de reprise de contact 115 et 117 sont destinés à être connectés à un circuit de communication radiofréquence d'un dispositif électronique.

Dans l'exemple représenté, le filtre 100 comprend en outre une ouverture 119 située à l'aplomb de la cavité 105. Dans cet exemple, l'ouverture 119 s'étend, depuis la face supérieure de la couche isolante 113, à travers les couches isolantes 113 et 109 et à travers une partie de la couche isolante 103 non revêtue de l'électrode 107 et s'étendant verticalement entre la face supérieure de la couche isolante 103 et la face supérieure de la cavité 105. Dans l'exemple illustré, la cavité 119 forme un orifice débouchant dans la cavité 105. L'ouverture 119 est par exemple un via formé pour permettre de retirer une couche sacrificielle préalablement formée dans la couche isolante 103 de sorte à réaliser la cavité 105. La couche sacrificielle est par exemple en silicium.

Dans l'exemple représenté, le filtre 100 comprend une membrane suspendue au-dessus de la cavité 105 et constituée d'une partie de la couche isolante 103 située à l'aplomb de l'électrode 111 et interposée entre la face supérieure de la cavité 105 et la face supérieure de la couche isolante 103. Le filtre 100 comprend par exemple une zone active constituée par des parties de l'électrode 111, de la couche isolante 109, de l'électrode 107 et de la couche isolante 103 situées au-dessus de la cavité 105 et à l'aplomb de l'électrode 111.

Les électrodes 107 et 111 et la partie de la couche isolante 109 interposée entre les électrodes 107 et 111 font par exemple partie d'un résonateur 121 du filtre 100. La couche isolante 109 est par exemple appelée couche active du résonateur 121 du filtre 100, en raison du fait que la couche isolante 109 est destinée à être excitée par un signal appliqué sur les électrodes 107 et 111 disposées de part et d'autre de cette couche.

En fonctionnement, un signal radiofréquence est par exemple appliqué, par les éléments de reprise de contact 115 et 117, entre les électrodes 107 et 111 du filtre 100. Le signal radiofréquence est par exemple une tension alternative. L'application, sur les électrodes 107 et 111, du signal radiofréquence provoque par exemple une alternance de phases d'expansion et de contraction de la couche isolante 109. Cela tend à faire résonner le résonateur 121 du filtre 100 et à faire vibrer la membrane du filtre 100. Dans un cas où le signal radiofréquence présente une fréquence sensiblement égale à une fréquence de résonance de la membrane du filtre 100, le signal radiofréquence n'est pas, ou est peu, atténué par le filtre 100. En revanche, dans un cas où le signal radiofréquence présente une fréquence différente de la fréquence de résonance de la membrane du filtre 100, le signal radiofréquence est fortement atténué par le filtre 100. Cela permet par exemple d'éviter que le fonctionnement d'un canal de réception de communications radiofréquence d'un dispositif électronique ne soit perturbé par des interférences causées par des signaux radiofréquence émis par d'autres dispositifs électroniques, ou par du bruit provenant de sources radiofréquence externes.

Un inconvénient du filtre 100 à ondes acoustiques de volume tient au fait que sa zone active est séparée du substrat semiconducteur 101 par une partie de la couche isolante 103 s'étendant verticalement depuis la face inférieure de l'électrode 107 jusqu'à la face supérieure 101T du substrat semiconducteur 101 (la partie de la couche isolante 103 située à gauche de la cavité 105, dans l'orientation de la figure 1). La couche isolante 103 étant en un matériau présentant une faible conductivité thermique, typiquement inférieure à celle du substrat 101, cela nuit par conséquent à une évacuation de calories produites par la zone active du filtre 100 lorsque la membrane vibre. Il en résulte un échauffement indésirable de la zone active du filtre 100, ce qui tend à dégrader ses performances.

Un autre inconvénient du filtre 100 réside dans la présence de la cavité 105 et de l'ouverture débouchante 119. Le filtre 100 présente, de ce fait, une robustesse mécanique relativement faible. Par ailleurs, les matériaux du substrat semiconducteur 101 et de la couche isolante 103 présentent des coefficients de dilatation thermique différents, ce qui tend également à fragiliser la structure en raison de variations de température liées au fonctionnement du filtre 100.

En outre, un inconvénient du filtre 100 tient au fait que la formation de la cavité 105 par retrait d'une couche sacrificielle constitue une étape particulièrement délicate à mettre en œuvre. Par ailleurs, des contraintes de planéité des couches isolantes 103, 109 et 113 et des électrodes 107 et 111 complexifient la réalisation du filtre 100.

Les inconvénients susmentionnés ont pour conséquence de limiter l'utilisation de filtres à ondes acoustiques de volume tels que le filtre 100 précédemment décrit en relation avec la figure 1 et font obstacle à la miniaturisation de ces filtres.

Un mode de réalisation permettant de pallier au moins en partie ces inconvénients est détaillé ci-après en relation avec la figure 2.

La figure 2 est une vue de côté et en coupe, schématique et partielle, d'un exemple de filtre 200 à ondes acoustiques de volume selon un mode de réalisation. Le filtre 200 est par exemple plus précisément un filtre FBAR.

Le filtre 200 de la figure 2 comprend des éléments en commun avec le filtre 100 de la figure 1. Ces éléments communs ne seront pas détaillés à nouveau ci-après.

Le filtre 200 de la figure 2 diffère du filtre 100 de la figure 1 en ce qu'il est dépourvu de la cavité 105 formée dans la couche isolante 103 et de l'ouverture 119. Selon un mode de réalisation, le filtre 200 comprend une cavité d'air 201 enterrée, ou enfouie, dans le substrat semiconducteur 101. Selon ce mode de réalisation, la cavité 201 est intégralement contenue dans le substrat semiconducteur 101. La cavité 201 est ainsi totalement close.

Dans l'exemple illustré, la cavité 201 est entièrement bordée par le matériau du substrat semiconducteur 101. La cavité 201 est, dans cet exemple, séparée de la face supérieure 101T du substrat semiconducteur 101, sensiblement plane, par une partie du substrat semiconducteur 101. La cavité 201 est par exemple située à une profondeur comprise entre quelques centaines de nanomètres et quelques micromètres sous la face supérieure 101T du substrat semiconducteur 101. En d'autres termes, la face supérieure de la cavité 201 est séparée de la face supérieure du substrat semiconducteur 101 par une partie du substrat 101 présentant par exemple une épaisseur comprise entre quelques centaines de nanomètres et quelques micromètres. L'épaisseur de la partie du substrat 101 interposée entre la face supérieure de la cavité 201 et la face supérieure 101T du substrat 101 est par exemple plus précisément comprise entre 300 nm et 1,5 µm.

Dans l'exemple représenté, la cavité 201 comprend des flancs arrondis, ou courbes, par exemple des flancs présentant une forme concave. À titre d'exemple, chaque flanc de la cavité 201 présente, en vue en coupe, une forme d'arc de cercle, par exemple de demi-cercle.

La cavité 201 présente par exemple, en vue de dessus, une forme rectangulaire. Cet exemple n'est toutefois pas limitatif, la cavité 201 pouvant plus généralement présenter, en vue de dessus, une forme quelconque, par exemple une forme polygonale autre que rectangulaire - par exemple carrée, triangulaire, hexagonale, etc. - ou une forme arrondie - par exemple ovale, circulaire, etc.

L'électrode 107 est au moins partiellement située à l'aplomb de la cavité 201. Comme dans l'exemple illustré en figure 2, l'électrode 107 est par exemple majoritairement située à l'aplomb de la cavité 201. Dans cet exemple, l'électrode 107 comprend en outre une partie minoritaire s'étendant latéralement hors de l'aplomb de la cavité 201.

Par ailleurs, l'électrode 111 est par exemple au moins partiellement située à l'aplomb de la cavité 201. Comme dans l'exemple illustré en figure 2, l'électrode 111 est par exemple totalement située à l'aplomb de la cavité 201. Dans cet exemple, l'électrode 111 présente des dimensions latérales strictement inférieures à celles de l'électrode 107.

Dans l'exemple illustré en figure 2, l'élément de reprise de contact 115 est situé sur et en contact avec une partie de la face supérieure de l'électrode 107 située hors de l'aplomb de la cavité 201. Cela permet d'éviter, ou de limiter, des perturbations du résonateur 121 du filtre 200 par rapport à un cas où l'élément de reprise de contact 115 serait en contact avec une partie de la face supérieure de l'électrode 107 située à l'aplomb de la cavité 201.

Dans le cas du filtre 200, la membrane du résonateur 121 est constituée par une partie du substrat semiconducteur 101 interposée entre la cavité 201 et la face supérieure 101T du substrat 101 et située à l'aplomb de l'électrode 111.

Bien que cela n'ait pas été illustré en figure 2, le filtre 200 peut en outre comporter un capot de protection du résonateur 121 du filtre 200, par exemple un capot prenant appui sur la face supérieure 101T du substrat semiconducteur 101 et à l'intérieur duquel sont situées les électrodes 107 et 111 et les couches isolantes 109 et 113 du filtre 200. La réalisation d'un tel capot de protection est à la portée de la personne du métier à partir des indications de la présente description.

Du fait que le filtre 200 est, contrairement au filtre 100, dépourvu de la cavité 105 située dans la couche isolante 103, la couche isolante 103 du filtre 200 présente par exemple une épaisseur très inférieure à celle de la couche isolante 103 du filtre 100. À titre d'exemple, la couche isolante 103 présente, dans le cas du filtre 200, une épaisseur comprise entre 0,5 et 1,5 µm, par exemple égale à 0,8 µm. Cela permet avantageusement d'améliorer la dissipation thermique du résonateur 121 du filtre 200 par rapport au filtre 100. La dissipation thermique est en outre facilitée du fait que les flancs de la cavité 201 présentent une forme arrondie.

Un autre avantage du filtre 200 tient au fait que la cavité 201 est située dans le substrat semiconducteur 101. Cela confère au filtre 200 une solidité mécanique supérieure à celle du filtre 100. Le fait que le filtre 200 soit dépourvu de l'ouverture 119 contribue en outre à l'amélioration de la solidité mécanique par rapport au filtre 100.

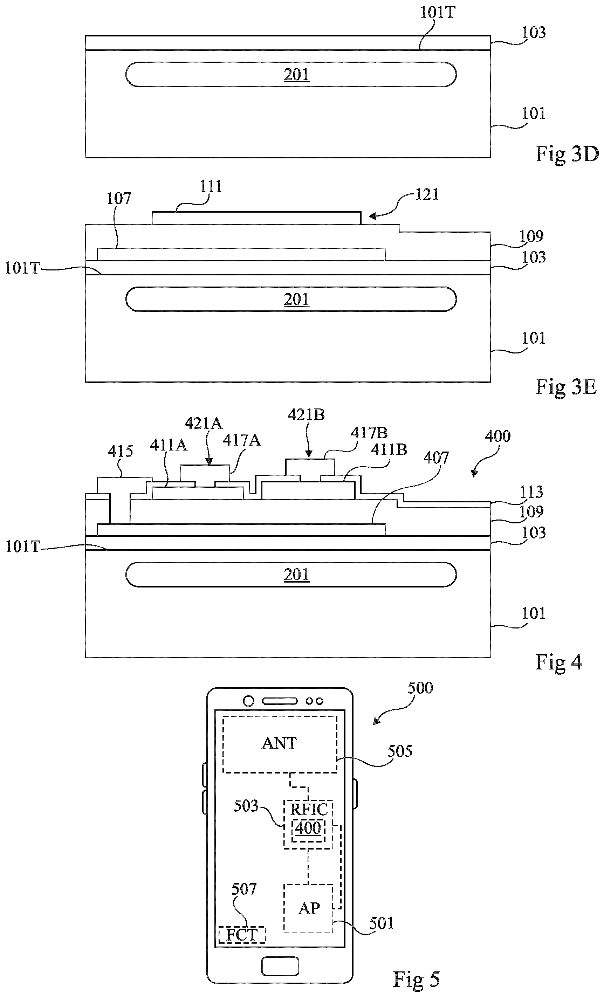

La figure 3A, la figure 3B, la figure 3C, la figure 3D et la figure 3E illustrent, par des vues de côté et en coupe, schématiques et partielles, des structures obtenues à l'issue d'étapes successives d'un procédé de fabrication du filtre 200 à ondes acoustiques de volume de la figure 2 selon un mode de réalisation.

La figure 3A illustre une structure obtenue à l'issue d'une étape de formation d'une pluralité de vias creux 301 dans le substrat semiconducteur 101.

Dans l'exemple illustré, les vias creux 301 s'étendent depuis la face supérieure 101T du substrat semiconducteur 101 jusqu'à une profondeur inférieure à l'épaisseur du substrat 101. Dit autrement, les vias creux 301 sont borgnes et ne débouchent pas du côté de la face inférieure du substrat 101.

Chaque via creux 301 présente par exemple, en vue de dessus, une section de forme sensiblement carrée. Cet exemple n'est toutefois pas limitatif, chaque via 301 pouvant plus généralement présenter, en vue de dessus, une forme quelconque, par exemple une forme polygonale autre que carrée - par exemple rectangulaire, triangulaire, hexagonale, etc. - ou une forme arrondie - par exemple ovale, circulaire, etc. À titre d'exemple, les vias creux 301 présentent des formes et des dimensions sensiblement identiques, aux dispersions de fabrication près. Les vias creux 301 présentent par exemple notamment une même profondeur, aux dispersions de fabrication près.

Les vias creux 301 sont par exemple agencés en réseau selon des lignes et des colonnes. Les lignes sont par exemple sensiblement perpendiculaires aux colonnes. Le réseau formé par les vias creux 301 présente par exemple, aux dispersions de fabrication près, un pas sensiblement constant, c'est-à-dire une distance centre-à-centre entre deux vias 301 voisins sensiblement constante.

Les vias creux 301 sont par exemple réalisés par photolithographie puis gravure. Pour cela, une couche de résine photosensible 303 est par exemple déposée du côté de la face supérieure 101T du substrat semiconducteur 101. La couche de résine photosensible 303 revêt par exemple toute la face supérieure 101T du substrat semiconducteur 101. Dans l'exemple représenté, la couche de résine photosensible 303 est plus précisément située sur et en contact avec la face supérieure 101T du substrat semiconducteur 101.

Des ouvertures traversantes sont par exemple ensuite formées dans la couche de résine photosensible 303 aux emplacements désirés des futurs vias creux 301, par exemple par insolation de la couche de résine photosensible 303 à travers un masque et retrait de parties insolées de la couche 303, dans le cas d'une résine positive, ou de parties non insolées de la couche 303, dans le cas d'une résine négative.

Une fois les ouvertures formées dans la couche de résine photosensible aux emplacements souhaités des futurs vias 301, les ouvertures sont par exemple ensuite prolongées dans le substrat semiconducteur 101 par gravure, par exemple par gravure ionique réactive (« Reactive Ion Etching » - RIE, en anglais), par exemple par gravure ionique réactive dite profonde (« Deep Reactive Ion Etching » - DRIE, en anglais).

La figure 3B illustre une structure obtenue à l'issue d'une étape ultérieure de retrait de la couche de résine photosensible 303.

Dans l'exemple représenté en figure 3B, la couche de résine photosensible 303 est intégralement retirée.

La figure 3C illustre une structure obtenue à l'issue d'une étape ultérieure de recuit du substrat semiconducteur 101 dans lequel ont préalablement été formés les vias creux 301.

Dans l'exemple illustré, le recuit conduit à la formation de la cavité 201 à partir des vias creux 301. Le recuit est par exemple effectué à une température de l'ordre de 1 000 °C, par exemple comprise entre 1 000 °C et 1 150 °C. Le recuit est par exemple en outre effectué sous atmosphère d'hydrogène, dans le cas où le substrat semiconducteur 101 est en silicium. Le fait de recuire sous hydrogène permet aux atomes de silicium du substrat semiconducteur 101 de présenter une mobilité de surface plus importante qu'en l'absence d'hydrogène.

Sous l'action du recuit, les atomes de silicium du substrat semiconducteur 101 se réorganisent de sorte que la structure présente une rugosité de surface et une énergie de surface minimales sans perte de volume. En pratique, les vias creux 301 tendent à s'évaser en partie inférieure, c'est-à-dire au voisinage de leur fond, et à se boucher en partie supérieure, c'est-à-dire au voisinage de la face supérieure 101T du substrat semiconducteur 101. Du fait de ces phénomènes, les vias creux 301 se transforment progressivement en la cavité 201 comme cela est illustré en figure 3C. Le fond de la cavité 201 est situé, dans le substrat semiconducteur 101, à une profondeur strictement inférieure à celle du fond des vias creux 301.

À titre d'exemple, la personne du métier pourra, pour la réalisation des étapes exposées ci-dessus en relation avec les figures 3A à 3C, s'inspirer de ce qui est décrit dans la publication de I. Mizushima et al. intitulée « Empty-space-in-silicon technique for fabricating a silicon-on-nothing structure » parue en novembre 2000 dans la revue Applied Physics Letters.

La figure 3D illustre une structure obtenue à l'issue d'une étape ultérieure de dépôt de la couche isolante 103 du côté de la face supérieure 101T du substrat semiconducteur 101.

Dans l'exemple représenté, la couche isolante 103 revêt toute la face supérieure 101T du substrat semiconducteur 101. La couche isolante 103 est par exemple plus précisément située sur et en contact avec toute la face supérieure 101T du substrat semiconducteur 101.

La figure 3E illustre une structure obtenue à l'issue d'une étape ultérieure de réalisation du résonateur 121.

Au cours de cette étape, l'électrode 107, la couche active 109 et l'électrode 111 sont successivement formées, dans cet ordre, sur la face 101T du substrat semiconducteur 101. L'électrode 107 est par exemple formée par dépôt d'une couche conductrice sur la face supérieure de la couche isolante 103 et par structuration, par exemple par photolithographie puis gravure, de la couche conductrice de sorte à conserver uniquement une partie de la couche conductrice correspondant à l'électrode 107.

La couche isolante 109 est par exemple ensuite déposée sur toute la face supérieure de la structure.

L'électrode 111 est par exemple alors réalisée de manière analogue ou identique à la réalisation de l'électrode 107, par exemple par dépôt d'une couche conductrice sur la face supérieure de la couche isolante 109 et par structuration, par exemple photolithographie puis gravure, de la couche conductrice de sorte à conserver uniquement une partie de la couche conductrice correspondant à l'électrode 111.

Bien que cela n'ait pas été illustré, la couche isolante 113 est par exemple ensuite déposée sur toute la face supérieure de la structure.

Les éléments de reprise de contact 115 et 117 sont alors par exemple formés par ouverture des couches isolantes 113 et 109 à l'aplomb de l'électrode 107, pour l'élément de reprise de contact 115, et par ouverture de la couche isolante 113 à l'aplomb de l'électrode 111, pour l'élément de reprise de contact 117. Une couche conductrice comblant les ouvertures est par exemple ensuite déposée sur toute la face supérieure de la structure et structurée, par exemple photolithographie puis gravure, de sorte à conserver uniquement des parties de la couche conductrice correspondant aux éléments de reprise de contact 115 et 117. À titre de variante, un dépôt localisé d'un matériau conducteur peut être prévu. Le filtre 200 est par exemple ainsi obtenu.

La figure 4 est une vue de côté et en coupe, schématique et partielle, d'un exemple de filtre 400 à ondes acoustiques de volume selon un mode de réalisation. Le filtre 400 de la figure 4 comprend des éléments en commun avec le filtre 200 de la figure 2. Ces éléments communs ne seront pas détaillés à nouveau ci-après.

Le filtre 400 de la figure 4 diffère du filtre 200 de la figure 2 en ce que le filtre 400 comprend deux résonateurs 421A et 421B situés au-dessus et à l'aplomb de la cavité 201.

Dans l'exemple représenté, le filtre 400 comprend une électrode 407 revêtant une partie de la face supérieure de la couche isolante 103. Dans l'exemple illustré, l'électrode 407 est située sur et en contact avec une partie de la face supérieure de la couche isolante 103. L'électrode 407 est au moins partiellement située à l'aplomb de la cavité 201. Comme dans l'exemple illustré en figure 4, l'électrode 407 est par exemple majoritairement située à l'aplomb de la cavité 201. Dans cet exemple, l'électrode 407 comprend en outre une partie minoritaire s'étendant latéralement hors de l'aplomb de la cavité 201. L'électrode 407 est par exemple analogue ou identique à l'électrode 107 du filtre 200. À titre d'exemple, l'électrode 407 est en un matériau conducteur, par exemple un métal tel que l'aluminium ou un alliage métallique.

L'électrode 407 constitue par exemple une électrode inférieure commune aux deux résonateurs 421A et 421B du filtre 400. Cela permet de simplifier la réalisation du filtre 400. Toutefois, cet exemple n'est pas limitatif et la personne du métier peut, à titre de variante, prévoir que chaque résonateur 421A, 421B du filtre 400 comporte une électrode inférieure isolée de celle de l'autre résonateur 421B, 421A.

La couche active 109 revêt l'électrode 407 du filtre 400. Dans l'exemple représenté, la couche active 109 est plus précisément située sur et en contact avec les parois latérales et supérieure de l'électrode 109. Par ailleurs, dans cet exemple, l'électrode 407 est commune aux deux résonateurs 421A et 421B du filtre 400. Cela permet de simplifier la réalisation du filtre 400. Toutefois, cet exemple n'est pas limitatif et la personne du métier peut, à titre de variante, prévoir que chaque résonateur 421A, 421B du filtre 400 comporte une couche active distincte de celle de l'autre résonateur 421B, 421A.

Dans l'exemple représenté, chaque résonateur 421A, 421B du filtre 400 comprend en outre une autre électrode 411A, 411B revêtant une partie de la face supérieure de la couche active 109. Dans l'exemple illustré, chaque électrode 411A, 411B est située sur et en contact avec une partie de la face supérieure de la couche isolante 109. Les électrodes 411A et 411B sont par exemple au moins partiellement situées à l'aplomb de la cavité 201. Comme dans l'exemple illustré en figure 4, chaque électrode 411A, 411B est par exemple totalement située à l'aplomb de la cavité 201. Dans cet exemple, chaque électrode 411A, 411B présente des dimensions latérales strictement inférieures à celles de l'électrode 407. Les électrodes 411A et 411B constituent par exemple des électrodes supérieures du filtre 400. À titre d'exemple, chaque électrode 411A, 411B est en un matériau conducteur, par exemple un métal tel que l'aluminium ou un alliage métallique. Les électrodes 411A et 411B sont par exemple en le même matériau que l'électrode 407.

Chaque électrode 411A, 411B présente par exemple, en vue de dessus, une forme asymétrique.

Selon un mode de réalisation, l'une des électrodes 411A, 411B présente une épaisseur différente de celle de l'autre électrode 411B, 411A. Dans l'exemple représenté, l'électrode 411A (située à gauche, dans l'orientation de la figure 4) présente une épaisseur inférieure à celle de l'électrode 411B (située à droite, dans l'orientation de la figure 4). Toutefois, cet exemple n'est pas limitatif et la personne du métier peut, à titre de variante, prévoir que l'électrode 411A présente une épaisseur strictement supérieure à celle de l'électrode 411B.

Dans l'exemple représenté, le filtre 400 comprend en outre des éléments de reprise de contact 415, 417A et 417B des électrodes 407, 411A et 411B, respectivement. Dans l'exemple illustré en figure 4, l'élément de reprise de contact 415 est situé sur et en contact avec une partie de la face supérieure de l'électrode 407 située hors de l'aplomb de la cavité 201. L'élément de reprise de contact 415 présente par exemple, en vue en coupe, une forme de T comprenant une partie verticale s'étendant, depuis la face supérieure de la couche isolante 113, à travers les couches isolantes 113 et 109 jusqu'à la face supérieure de l'électrode 407 et une partie horizontale s'étendant latéralement sur et en contact avec la face supérieure de la couche isolante 113 au voisinage de la partie verticale de l'élément de reprise de contact 415.

Par ailleurs, dans cet exemple, l'élément de reprise de contact 417A, 417B est situé sur et en contact avec une partie de la face supérieure de l'électrode 411A, 411B située à l'aplomb de la cavité 201. L'élément de reprise de contact 417A, 417B présente par exemple, en vue en coupe, une forme de T comprenant une partie verticale s'étendant, depuis la face supérieure de la couche isolante 113, à travers la couche isolante 113 jusqu'à la face supérieure de l'électrode 411A, 411B et une partie horizontale s'étendant latéralement sur et en contact avec la face supérieure de la couche isolante 113 au voisinage de la partie verticale de l'élément de reprise de contact 417A, 417B. Chaque élément de reprise de contact 415, 417A et 417B est en un matériau conducteur, par exemple un métal ou un alliage métallique. À titre d'exemple, les éléments de reprise de contact 417A et 417B sont en le même matériau que l'élément de reprise de contact 415.

Bien que cela n'ait pas été illustré en figure 4 afin de ne pas surcharger le dessin, les éléments de reprise de contact 415, 417A et 417B sont par exemple destinés à être reliés ou connectés à un ou plusieurs composants ou circuits extérieurs au filtre 400. À titre d'exemple, les éléments de reprise de contact 415, 417A et 417B sont destinés à être connectés à un circuit de communication radiofréquence d'un dispositif électronique.

Le fait de prévoir que les électrodes 411A et 411B présentent des épaisseurs différentes permet aux résonateurs 421A et 421B de présenter des fréquences de résonance différentes. Dans ce cas, le filtre 400 est par exemple un filtre passe-bande, par exemple un filtre laissant passer des signaux présentant une fréquence comprise dans une bande de fréquences sensiblement délimitée par les fréquences de résonance des résonateurs 421A et 421B. À titre d'exemple, la bande passante du filtre 400 est de l'ordre du gigahertz, par exemple comprise entre 0,5 et 6 GHz.

Le filtre 400 présente des avantages analogues à ceux précédemment décrits en relation avec la figure 2 dans le cas du filtre 200, notamment en termes de performances thermiques et de robustesse mécanique.

La figure 5 est une vue de dessus, schématique et partielle, d'un exemple d'un dispositif 500 intégrant un filtre à ondes acoustiques de volume, par exemple le filtre 400 précédemment décrit en relation avec la figure 4. Dans l'exemple représenté, le dispositif 500 est un téléphone mobile, ou smartphone.

Dans cet exemple, le dispositif 500 comprend un circuit de traitement 501 (AP), par exemple un microcontrôleur ou un microprocesseur principal du dispositif 500. Le circuit de traitement 501 est par exemple connecté à un circuit intégré radiofréquence 503 (RFIC) comprenant au moins un filtre du type du filtre 200 ou 400, par exemple un filtre 400. Le filtre 400 est par exemple intégré dans un circuit électronique de filtrage, non détaillé en figure 5. Dans l'exemple illustré, le circuit intégré radiofréquence 503 est connecté à une antenne 505 (ANT), par exemple une antenne de communication radiofréquence du dispositif 500. Bien que cela n'ait pas été détaillé en figure 5 afin de ne pas surcharger le dessin, le circuit intégré radiofréquence 503 peut en outre comprendre des composants et circuits destinés à mettre en œuvre des fonctions d'adaptation d'impédance, d'amplification, de modulation/démodulation, de commutation, etc.

Le dispositif 500 peut en outre comprendre d'autres éléments, par exemple d'autres composants électroniques ou circuits non détaillés en figure 5. Ces éléments ont été symbolisés, en figure 5, par un bloc fonctionnel 507 (FCT).

Bien que la figure 5 illustre un cas dans lequel le filtre 400 est intégré dans le dispositif 500, cet exemple n'est pas limitatif et la personne du métier est capable de prévoir, à partir des indications de la présente description, de substituer, dans le dispositif 500, le filtre 400 par le filtre 200 ou par un filtre présentant une structure analogue à celle du filtre 200 ou 400.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que la figure 4 prenne pour exemple un cas dans lequel le filtre 400 comprend deux résonateurs 421A et 421B situés au-dessus de la cavité 201, la personne du métier est bien entendu capable, à partir des indications de la présente description, de transposer le mode de réalisation de la figure 4 à un nombre quelconque de résonateurs situés au-dessus d'une même cavité réalisée dans un substrat semiconducteur.

À partir des indications de la présente description, la personne du métier est en outre capable de réaliser plusieurs filtres dans un même substrat semiconducteur, par exemple en prévoyant de former plusieurs cavités enterrées dans un même substrat semiconducteur et au moins un résonateur situé à l'aplomb de chaque cavité.

Par ailleurs, bien que la figure 5 prenne pour exemple le cas d'une intégration du filtre 400 dans un téléphone mobile ou un smartphone, les modes de réalisation décrits ne se limitent pas à cet exemple mais s'appliquent plus généralement à tout dispositif ou système doté de fonctions de communication sans fil, par exemple dans le domaine de la télématique. En particulier, le filtre 400 ou le filtre 200 peut être intégré dans des véhicules automobiles, par exemple pour mettre en œuvre des fonctionnalités d'accès à Internet sans fil, de communication du véhicule avec des équipements ou systèmes extérieurs, de conduite autonome, etc. pour des applications finales telles que la gestion de flottes de véhicules (emplacement, mouvement, état et comportement de chaque véhicule) ou les systèmes de navigation en temps réel, ou encore pour permettre à des objets de communiquer avec un véhicule (par exemple dans le cadre de l'internet des objets - IoT), le tout sans interférences par des systèmes non acceptés dans un « cercle » de communication autorisé.

Enfin, la mise en œuvre pratique des modes de réalisation et variantes décrits est à la portée de la personne du métier à partir des indications fonctionnelles données ci-dessus. En particulier, la réalisation du filtre 400 est à la portée de la personne du métier à la lecture de la présente description, notamment à partir du procédé de fabrication du filtre 200 décrit en relation avec les figures 3A à 3E.

Par ailleurs, les modes de réalisation décrits ne se limitent pas aux exemples particuliers de matériaux et de dimensions mentionnés dans la présente description.

## Revendications

1. Filtre (200 ; 400) à ondes acoustiques de volume formé dans et sur un substrat semiconducteur (101), le filtre (200 ; 400) comprenant :
- une cavité d'air (201) enterrée dans le substrat semiconducteur (101) ; et
- au moins un résonateur (121 ; 421A, 421B) formé à l'aplomb de la cavité d'air (201), chaque résonateur (121 ; 421A, 421B) comprenant une couche active (109) interposée entre des électrodes inférieure (107 ; 407) et supérieure (111 ; 411A, 411B).

2. Filtre (200) selon la revendication 1, comprenant un unique résonateur (121) formé à l'aplomb de la cavité d'air (201).

3. Filtre (400) selon la revendication 1, comprenant exactement des premier (421A) et deuxième (421B) résonateurs formés à l'aplomb de la cavité d'air (201).

4. Filtre (400) selon la revendication 3, dans lequel les électrodes supérieures (411A, 411B) des premier (421A) et deuxième (421B) résonateurs présentent des épaisseurs différentes.

5. Filtre (400) selon la revendication 3 ou 4, dans lequel les électrodes inférieures des premier (421A) et deuxième (421B) résonateurs forment une électrode (407) commune.

6. Filtre (200 ; 400) selon l'une quelconque des revendications 1 à 5, dans lequel chaque électrode supérieure (111 ; 411A, 411B) présente, en vue de dessus, une forme asymétrique.

7. Filtre (200 ; 400) selon l'une quelconque des revendications 1 à 6, dans lequel le substrat semiconducteur (101) est en silicium.

8. Filtre (200 ; 400) selon l'une quelconque des revendications 1 à 7, dans lequel chaque résonateur (121 ; 421A, 421B) est séparé de la cavité d'air (201) par une partie du substrat semiconducteur (101) présentant une épaisseur comprise entre 300 nm et 1,5 µm.

9. Dispositif électronique (500), de préférence téléphone mobile ou smartphone, comprenant un circuit intégré radiofréquence (503) comportant au moins un filtre (200 ; 400) selon l'une quelconque des revendications 1 à 8.

10. Procédé de fabrication d'un filtre (200 ; 400) à ondes acoustiques de volume, le procédé comprenant les étapes successives suivantes :
a) prévoir un substrat semiconducteur (101) ;
b) former une cavité d'air (201) enterrée dans le substrat semiconducteur (101) ; et
c) former au moins un résonateur (121 ; 421A, 421B) à l'aplomb de la cavité d'air (201), chaque résonateur (121 ; 421A, 421B) comprenant une couche active (109) interposée entre des électrodes inférieure (107 ; 407) et supérieure (111 ; 411A, 411B).

11. Procédé selon la revendication 10, comprenant en outre, entre les étapes a) et b), une étape de formation d'une pluralité de vias creux (301) dans le substrat semiconducteur (101).

12. Procédé selon la revendication 11, dans lequel, à l'étape b), la cavité d'air (201) est formée, à partir de la pluralité de vias creux (301), par recuit du substrat semiconducteur (101) sous atmosphère d'hydrogène.
